# EUROPÄISCHE PATENTSCHRIFT

(11) **EP 0 584 478 B1**
(45) Veröffentlichungstag und Bekanntmachung des Hinweises auf die Patenterteilung: **13.08.1997**
(21) Anmeldenummer: 93109733.1
(22) Anmeldetag: 18.06.1993
(51) Int. Cl.: G01D 18/00

(54) **Verfahren zur Herstellung eines Anzeigegeräts**
Method of manufacture of a display device
Méthode de construction d'un dispositif d'affichage

(30) Priorität: 06.08.1992 DE 4226017
(43) Veröffentlichungstag der Anmeldung: 02.03.1994
(73) Patentinhaber: VDO Adolf Schindling AG, D-60487 Frankfurt (DE)
(72) Erfinder: Mittenbühler, Karl-Heinz, D-6103 Griesheim (DE); Blume, Heinrich-Jochen, Dr., D-6100 Darmstadt (DE)
(74) Vertreter: Müller, Kurt, Dipl.-Ing.

(56) Entgegenhaltungen:
- DE-A- 3 921 462

## Beschreibung

Die Erfindung bezieht sich auf ein Verfahren zur Montage eines Getriebes in einem elektronisch synchronisierbaren Anzeigegerät, nach dem Oberbegriff des Patentanspruchs 1.

Bei derartigen Anzeigegeräten kann man wegen der Zwischenschaltung des mehrstufigen Getriebes zwischen Motorritzel und Zeigerwelle, aus der im Zählwerk eines Mikroprozessors gespeicherten Schrittzahl, d. h. von der Position des Schrittmotor-Rotors keine sicheren Rückschlüsse auf die Zeiger-Position ziehen, weil der gespeicherte Zahlenwert aus verschiedenen Gründen gestört sein kann. Damit daraus keine Fehlanzeigen entstehen, muß das Zählwerk immer wieder neu mit der Zeigerposition synchronisiert werden. Dazu wird bei dem Verfahren gemäß DE-OS 39 21 462 die durch einen mechanischen Anschlag definierten Nullposition des Zeigers in Verbindung mit einem Prüfprogramm benutzt, bei dem der Schrittmotor solange im Sinne einer Zeigerbewegung in Richtung Nullposition angesteuert wird, bis das Ende der Zeigerbewegung am Ausbleiben einer induzierten Spannung in der jeweils nicht zum Antrieb des Zeigers bestromten Wicklung des Schrittmotors festgestellt wird. Danach wird das Zählwerk auf Null bzw. auf den zur Nullposition des Zeigers gehörenden Wert gesetzt.

Dieses Verfahren arbeitet zufriedenstellend, benötigt bei 90°-Schritten pro Rotorumdrehung aber vier Umschaltungen und vier Prüfroutinen, was schaltungstechnisch als zu aufwendig bemängelt wird. In der Patentanmeldung EP-A-0 551 562 (P 42 00 551) ist daher schon vorgeschlagen worden, beim Zusammenbau von Schrittmotor und Anzeigegerät der Nullposition des Zeigers eine bestimmte Ausrichtung des zweipoligen Rotors zuzuordnen. Zu Beginn des Synchronisierverfahrens wird der Rotor jeweils zunächst in diese bestimmte Ausrichtung gebracht. Zur Feststellung der Induktion bzw. von deren Ausbleiben, muß dann nur noch die um einen Schritt auf diese bestimmte Ausrichtung folgende Position des Rotors geprüft werden. Durch die Zuordnung einer bestimmten Ausrichtung des Rotors zur Nullposition des Zeigers wird eine Art einmaliger, mechanischer Vorsynchronisation erreicht. Dadurch ist sichergestellt, daß die Nullposition des Zeigers nur bei einem bestimmten Schritt des Rotors erreicht werden kann, wodurch bei 90°-Schritten jeweils nur einer von vier Schritten überprüft werden muß und der Schaltungsaufwand gegenüber dem alten Verfahren um 50 % reduziert werden kann, weil nur noch eine der beiden Wicklungen alternativ an die Spannungsquelle und das Meßwerk angeschlossen werden muß.

Es hat sich jedoch herausgestellt, daß die bei der Montage vorzunehmende Zuordnung von Zeigerstellung und Rotorposition mit einigen Schwierigkeiten verbunden ist. In einem konkreten Anwendungsfall ist ein dreistufiges Getriebe mit einem Übersetzungsverhältnis von 1 : 43 vorgesehen. Dabei muß man mit einem Getriebespiel von etwa 30° rechnen. Um dies zu vermeiden, ist eine Feder vorgesehen, die den Zeiger in einer Drehrichtung vorspannt. Diese Vorspannung bleibt auch bei Drehrichtungsumkehr erhalten.

Aus Gründen der Geräuschdämmung werden nur ungradzahlige Zahnräder benutzt. Das hat zur Folge, daß das Getriebe in einer ganz bestimmten Konstellation zusammengesetzt werden muß, wenn Rotor und Zeiger in der für das verkürzte Synchronisierverfahren erforderlichen Weise einander zugeordnet sein sollen. Die Montage des Getriebes ist daher sehr mühsam und birgt außerdem erhebliche Fehlermöglichkeiten.

Es besteht somit die Aufgabe, die Voraussetzungen für die Anwendung des verkürzten Synchronisierverfahrens mit weniger Aufwand und geringeren Fehlerquoten zu schaffen, d. h. die mechanische Vorsynchronisation in einer für die Serienfertigung brauchbaren, einfachen Weise und mit größerer Sicherheit zu realisieren.

Diese Aufgabe wird erfindungsgemäß durch die Merkmale des Kennzeichens des Patentanspruchs 1 gelöst.

Zweckmäßige Ausgestaltungen und Weiterbildungen der Erfindung sind in den Ansprüchen 2 bis 7 gefaßt. Bei der Verwendung eines nichtmagnetisierten Rotors können die Zahnräder des mehrstufigen Getriebes zwischen Motorritzel und Zeigerwelle ohne irgendeinen Zuordnungszwang montiert werden. Sie können "zusammengeschüttelt" werden, müssen schließlich nur mechanisch richtig miteinander im Eingriff stehen. Anschließend wird der Zeiger gegen die Rückstellkraft der Feder durch ein von außen aufgebrachtes Drehmoment in die Nullposition gebracht. Danach wird der Rotor durch ein magnetisches Drehfeld unter Mitnahme der Getrieberäder in Richtung Nullanschlag des Zeigers gedreht, bis kein Getriebespiel mehr vorhanden ist. Erst dann wird der Rotor magnetisiert, d. h. er erhält seine zweipolige Ausrichtung, wobei verfahrensbedingt gleichzeitig eine bestimmte Ausrichtung der Pole zur Nullposition des Zeiger hergestellt wird. Damit ist die für das verkürzte elektronische Synchronisierverfahren notwendige mechanische Vorsynchronisation erreicht. Sie kann keine Montagefehler aufweisen, weil die Zuordnung von Rotor und Zeiger erst nach Abschluß der Montage vorgenommen wird. Sie ist auch unverlierbar, solange man das Getriebe nicht auseinandernimmt.

## Patentansprüche

1. Verfahren zur Montage eines Getriebes in einem elektronisch synchronisierbaren Anzeigegerät, das zwischen einem aus magnetisierbarem Material bestehenden Rotor eines Schrittmotors, der zwei senkrecht zueinander angeordnete Spulen aufweist, und einem Zeiger angeordnet wird, **dadurch gekennzeichnet**, daß das Getriebe ohne einen Zuordnungszwang montiert wird, wobei der bisher nichtmagnetisierte Rotor mittels eines magnetischen Drehfelds in Richtung Nullanschlag des Zeigers gegen die Kraft einer Drehfeder gedreht wird, bis kein Getriebespiel mehr vorhanden ist, wonach der Rotor in dieser Position magnetisiert wird.

2. Verfahren nach Anspruch 1, dadurch gekennzeichnet, daß das magnetische Drehfeld erzeugt wird, indem die Spulen des Schrittmotors mit einem elektrischen Wechselfeld beaufschlagt werden.

3. Verfahren nach Anspruch 2, dadurch gekennzeichnet, daß das elektrische Wechselfeld mittels zweier um 90° zueinander versetzte Spannungen erzeugt wird.

4. Verfahren nach Anspruch 3, dadurch gekennzeichnet, daß ein Wechselfeld mit einer Frequenz von 5 Hz bis 10 kHz verwendet wird.

5. Verfahren nach Anspruch 1, dadurch gekennzeichnet, daß das magnetische Drehfeld durch Drehung eines Magneten erzeugt wird.

6. Verfahren nach Anspruch 5, dadurch gekennzeichnet, daß die Frequenz des magnetischen Drehfeldes 2 Hz bis 200 Hz beträgt.

7. Verfahren nach einem der Ansprüche 1 bis 6, dadurch gekennzeichnet, daß eine Drehfeder benutzt wird, deren maximales Rückstellmoment kleiner ist als das Rastmoment des magnetisierten Rotors im Gehäuse.

## Claims

1. A method of installing a gearing unit in an electronically synchronisable indicating device, which gearing unit is disposed between a rotor, which consists of magnetisable material, of a stepper motor which comprises two coils disposed perpendicularly to each other, and a pointer, **characterised in that** the gearing unit is installed without any associative constraint, wherein the rotor, which was previously unmagnetised, is rotated towards the zero stop of the pointer by means of a rotating magnetic field against the force of a torsion spring until free motion in the gearing unit is no longer present, after which the rotor is magnetised in this position.

2. A method according to claim 1, characterised in that the rotating magnetic field is generated by an alternating electric field which acts on the coils of the stepper motor.

3. A method according to claim 2, characterised in that the alternating electric field is generated by means of two voltages displaced by 90° in relation to each other.

4. A method according to claim 3, characterised in that an alternating field with a frequency of 5 Hz to 10 kHz is used.

5. A method according to claim 1, characterised in that the rotating magnetic field is generated by the rotation of a magnet.

6. A method according to claim 5, characterised in that the frequency of the rotating magnetic field is 2 Hz to 200 Hz.

7. A method according to any one of claims 1 to 6, characterised in that a torsion spring is used, the maximum restoring moment of which is less than the latching moment of the magnetised rotor in the housing.

## Revendications

1. Méthode de montage d'un mécanisme dans un appareil indicateur à synchronisation électronique, qui est disposé entre un rotor, constitué d'un matériau magnétisable, d'un moteur pas à pas qui présente deux bobines disposées perpendiculairement l'une à l'autre, et une aiguille, caractérisée par le fait que l'on monte le mécanisme sans aucune obligation de correspondance, méthode dans laquelle, au moyen d'un champ tournant magnétique, on fait tourner le rotor, non magnétisé jusqu'alors, dans le sens de la butée zéro de l'aiguille, à l'encontre de la force d'un ressort de torsion, jusqu'à ce qu'il n'y ait plus de jeu dans le mécanisme, après quoi on magnétise le rotor dans cette position.

2. Méthode selon la revendication 1, caractérisée par le fait que l'on produit le champ tournant magnétique en faisant passer un champ électrique alternatif dans les bobines du moteur pas à pas.

3. Méthode selon la revendication 2, caractérisée par le fait que l'on produit le champ électrique alternatif au moyen de deux tensions décalées de 90° l'une par rapport à l'autre.

4. Méthode selon la revendication 3, caractérisée par le fait que l'on emploie un champ alternatif d'une fréquence de 5 Hz à 10 kHz.

5. Méthode selon la revendication 1, caractérisée par le fait que l'on produit le champ tournant magnétique en faisant tourner un aimant.

6. Méthode selon la revendication 5, caractérisé par le fait que la fréquence du champ tournant magnétique vaut de 2 Hz à 200 Hz.

7. Méthode selon l'une des revendications 1 à 6, caractérisée par le fait que l'on utilise un ressort de torsion dont le moment de rappel maximal est inférieur au moment d'indexage du rotor magnétisé dans le carter.
